Europäisches Patentamt

European Patent Office

Office européen des brevets

(19)

(11) Veröffentlichungsnummer: **0 070 026**
A2

(12) # EUROPÄISCHE PATENTANMELDUNG

(21) Anmeldenummer: 82106229.6

(22) Anmeldetag: 12.07.82

(51) Int. Cl.³: **G 11 C 5/00**

(30) Priorität: 15.07.81 DE 3128014

(43) Veröffentlichungstag der Anmeldung:
19.01.83 Patentblatt 83/3

(84) Benannte Vertragsstaaten:
DE FR GB

(71) Anmelder: SIEMENS AKTIENGESELLSCHAFT
Berlin und München Wittelsbacherplatz 2
D-8000 München 2(DE)

(72) Erfinder: Schindlbeck, Günter
Habichtstrasse 1a
D-8000 München 82(DE)

(54) **Anordnung zur Reduzierung der Empfindlichkeit von integrierten Halbleiterspeichern gegen Alpha-Strahlung.**

(57) In integrierten dynamischen Halbleiter-Schreib-Lese-speichern (RAM's) mit Ein-Transistor-Speicherzellen (12, 13, 14, 14; 15', 16) ist zur Reduzierung der Empfindlichkeit gegen Alpha-Strahlung vorgesehen, daß der Transfer-Transistor (12, 13, 14; 12, 13, 14') und der Speicherkondensator (12, 13, 15; 12, 13, 15') der Ein-Transistor-Speicherzellen in einer Schicht (12) aus polykristallinem Silicium ausgebildet sind, die gegen ein Silicium-Substrat (10) durch eine Isolations-schicht (11) getrennt ist.

FIG 2

EP 0 070 026 A2

Croydon Printing Company Ltd.

SIEMENS AKTIENGESELLSCHAFT
Berlin und München

— 1 —

Unser Zeichen
VPA 81 P 1 0 9 2 E

Anordnung zur Reduzierung der Empfindlichkeit von integrierten Halbleiterspeichern gegen Alpha-Strahlung.

Die vorliegende Erfindung betrifft eine Anordnung zur Reduzierung der Empfindlichkeit von integrierten Halbleiterspeichern, insbesondere dynamischen Schreib-Lesespeichern (RAM's) mit Ein-Transistor-Speicherzellen gegen Alpha-Strahlung.

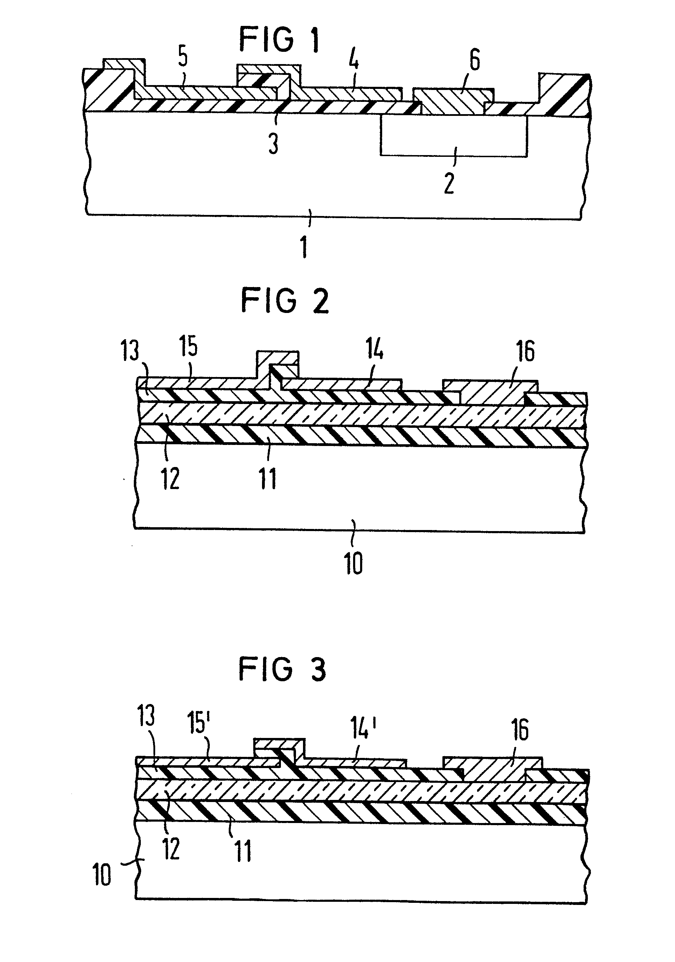

Halbleiterspeicher der vorgenannten Art sind sehr empfindlich gegen Alpha-Strahlung. Eine bekannte Ein-Transistor-Speicherzelle eines Halbleiter-Schreib-Lesespeichers (RAM's) ist schematisch in Figur 1 dargestellt. Bei dieser Speicherzelle ist in einem üblicherweise aus Silicium bestehendem Substrat 1 eine beispielsweise durch Diffusion hergestellte Zone 2 vorgesehen, welche als Bit-Leitung für den Speicher dient. Diese Zone 2 ist durch eine Elektrode 6 aus leitendem Material kontaktiert und damit elektrisch zugänglich. Auf dem Substrat 1 ist eine beispielsweise aus Siliciumdioxid bestehende Isolierschicht 3 vorgesehen, welche als Gate-Oxid für den Transfer - Transistor der Speicherzelle und als Dielektrikum für einen Speicherkondensator der Speicherzelle dient. Auf dieser Isolierschicht 3 ist eine Transfer - Elektrode 4 aus leitendem Material vorgesehen, welche das Transfer-Gate des Transfer-Transistors der Speicherzelle bildet. Weiterhin ist auf der Isolierschicht 3 eine weitere Elektrode 5 aus leitendem Material vorgesehen, welche eine Elektrode des Speicherkondensators der Speicherzelle bildet.

Lz 1 Gae / 13.07.1981

Bei Bestrahlung mit Alpha-Teilchen werden in der vorstehend beschriebenen Speicherzelle Störladungen in Form von Elektronen-Loch-Paaren erzeugt, welche in den Raumladungsgebieten des Speicherkondensators und der Bitleitung getrennt werden und damit zu Fehlern führen. Mit anderen Worten ausgedrückt werden die Störladungen durch die Raumladungsgebiete gesammelt, so daß auch die erzeugten Elektronen in der Speicherzelle gespeichert werden können. Übersteigt der Anteil der durch Alpha-Strahlung hervorgerufenen Ladungsträger einen kritischen Wert, so ergibt sich ein Fehler, der als "soft error" bezeichnet wird.

Zur Vermeidung oder wenigstens zur Reduzierung derartiger Fehler ist bereits versucht worden, durch eine möglichst große Zellenladung den Einfluß der Störladung so gering wie möglich zu halten.

Weiterhin ist auch bekannt geworden, Systeme der anhand von Figur 1 erläuterten Art mit organischen Substanzen, beispielsweise mit Polyimid abzudecken, um die Alpha-Strahlung vom System ferzuhalten. Eine derartige Abdeckung beeinträchtigt jedoch die Montage-Ausbeute und die Zuverlässigkeit der Halbleiterspeicher, was insbesondere bei Kunststoff-Gehäusen der Fall ist.

Der Erfindung liegt die Aufgabe zu Grunde, eine Möglichkeit zu schaffen, die Trennung der durch Alpha-Strahlung erzeugten Ladungsträger-Spaare und damit deren elektrisches Wirksamwerden zu unterbinden.

Diese Aufgabe wird bei einer Anordnung der eingangs genannten Art erfindungsgemäß dadurch gelöst, daß der Transfer-Transistor und der Speicherkondensator der Ein-Transistor-Speicherzellen in einer Schicht aus polykristallinem Halbleitermaterial, insbesondere Silicium ausgebildet sind, die gegen ein Substrat aus Halbleitermaterial, insbesondere aus Silicium, durch eine Isolationsschicht getrennt ist.

Ausgestaltungen des vorstehend definierten Erfindungsgedankens sind in Unteransprüchen gekennzeichnet.

Die Erfindung wird in folgenden anhand von in den Figuren
2 und 3 der Zeichnung dargestellten Ausführungsbeispielen
näher erläutert. Es zeigt:

Figur 2 - einen Schnitt einer Ausführungsform einer
erfindungsgemäßen Anordnung;

Figur 3 - einen Schnitt einer weiteren Ausführungsform
einer erfindungsgemäßen Anordnung.

Bei der Ausführungsform nach Figur 2 ist auf einem Substrat 10 aus Silicium eine Isolationsschicht 11 vorgesehen, welche durch Siliciumdioxid oder Siliciumnitrid
gebildet ist. Auf dieser Isolationsschicht 11 ist eine
Schicht 12 aus polykristallinem Silicium vorgesehen,
welche einen Transfer-Transistor und einen Speicherkondensator einer Ein-Transistor-Speicherzelle enthält.

Die Ausbildung der Komponenten von Speicherzellen ist
in einer polykristallinen Siliciumschicht an sich bekannt.

Auf der Schicht aus polykristallinem Silicium ist eine
weitere Isolationsschicht 13 vorgesehen, welche ebenfalls beispielsweise aus Siliciumdioxid oder Siliciumnitrid hergestellt sein kann. Eine auf der Isolationsschicht 13 vorgesehene Elektrode 14 aus leitendem Material bildet das Gate des Transfer-Transistors der
Speicherzelle. Eine weitere Elektrode 15 aus leitendem Material, welche gegebenenfalls auch entfallen kann, bildet eine obere Deckelektrode der Speicherzelle.

Schließlich bildet eine Elektrode 16 aus leitendem Material die Bit-Leitung der Speicherzelle.

Bei der vorstehend beschriebenen erfindungsgemäßen Anordnung ist das Substrat 10 durch die Isolationsschicht 11 von der die wirksamen Komponenten der Speicherzelle enthaltenden Schicht 12 aus hochohmigen Halbleitermaterial getrennt, so daß im Substrat 10 durch Alpha-Strahlung erzeugte Ladungsträger-Paare keine Fehler durch Störladungen in den Komponenten der Ein-Transistor-Speicherzelle hervorrufen können.

Figur 3, in der gleiche Komponenten wie in Figur 2 mit gleichen Bezugszeichen versehen sind, ist im Gegensatz zur Anordnung nach Figur 2, bei der die obere Deckelektrode 15 über die Transfer-Gate-Elektrode 14 über eine obere Deckelektrode 15 gezogen. Im übrigen ist die Anordnung nach Figur 3 ebenso wie die Anordnung nach Figur 2 ausgebildet.

3 Figuren

5 Patentansprüche

Patentansprüche

1. Anordnung zur Reduzierung der Empfindlichkeit von integrierten Halbleiterspeichern, insbesondere dynamischen Schreib-Lesespeichern (RAM's) mit Ein-Transistor-Speicherzellen gegen Alpha-Strahlung, d a d u r c h   g e k e n n -z e i c h n e t,  daß der Transfer-Transistor (12,13,14; 12, 13, 14') und der Speicherkondensator (12, 13, 15; 12, 13, 15') der Ein-Transistor-Speicherzellen in einer Schicht (12) aus hochohmigen Halbleitermaterial, insbesondere Silicium, ausgebildet sind, die gegen ein Substrat (10) aus Halbleitermaterial, insbesondere Silicium, durch eine Isolationsschicht (11) getrennt ist.

2. Anordnung nach Anspruch 1, d a d u r c h   g e k e n n -z e i c h n e t,  daß als Schicht (12) aus hochohmigen Halbleitermaterial eine Schicht aus polykristallinem Halbleitermaterial, insbesondere Silicium vorgesehen ist.

3. Anordnung nach Anspruch 1 und/oder 2,  d a d u r c h   g e k e n n z e i c h n e t,  daß die Isolationsschicht (11) durch ein Oxid des Halbleitermaterials, insbesondere Siliciumdioxid gebildet ist.

4. Anordnung nach Anspruch 1 und/oder 2,  d a d u r c h   g e k e n n z e i c h n e t, daß die Isolationsschicht (11) durch ein Nitrid des Halbleitermaterials, insbesondere Siliciumnitrid gebildet ist.

5. Ansprüche 1 bis 3, d a d u r c h    g e k e n n -
z e i c h n e t,  daß auf der Schicht (12) aus hochohmigem Halbleitermaterial eine weitere Isolationsschicht
(13) vorgesehen ist, die als Gate-Isolator des Transfer-
Transistors und als Dielektrikum des Speicherkondensators
der Ein-Transistor-Speicherzellen dient.

1/1

## FIG 1

## FIG 2

## FIG 3